Europäisches Patentamt

European Patent Office

Office européen des brevets

(11) Numéro de publication: **0 356 327 B1**

(12) **FASCICULE DE BREVET EUROPEEN**

(45) Date de publication de fascicule du brevet: **01.12.93**  (51) Int. Cl.5: **H04R 3/00**, H04B 15/00, H03H 17/00

(21) Numéro de dépôt: **89402308.4**

(22) Date de dépôt: **18.08.89**

(54) **Dispositif de saisie de signaux sonores à élimination de brouilleur.**

(30) Priorité: **19.08.88 FR 8811042**

(43) Date de publication de la demande:
**28.02.90 Bulletin 90/09**

(45) Mention de la délivrance du brevet:
**01.12.93 Bulletin 93/48**

(84) Etats contractants désignés:
**DE ES GB IT SE**

(56) Documents cités:
**EP-A- 0 084 982**
**US-A- 4 653 102**
**US-A- 4 723 294**

**ELECTRONICS & COMMUNICATIONS IN JA-**
**PAN, vol. 67, no. 12, décembre 1984, pages**
**19-28, Scripta Publishing Co., Silver Spring,**
**Maryland, US; Y. KANEDA et al.: "Noise sup-**
**pression signal processing using 2-point re-**
**ceived signals"**

(73) Titulaire: **FRANCE TELECOM**
**6, Place d'Alleray**
**F-75015 Paris(FR)**

(72) Inventeur: **Grenier, Yves**
**17 Rue Bayet**
**F-75013 Paris(FR)**
Inventeur: **Xu, Min**
**31 Villa Curial**
**F-75009 Paris(FR)**

(74) Mandataire: **Fort, Jacques et al**
**CABINET PLASSERAUD**
**84, rue d'Amsterdam**
**F-75009 Paris (FR)**

EP 0 356 327 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services
(3.10/3.6/3.3.1)

## Description

L'invention a pour objet un dispositif de saisie de signaux sonores fournis par des sources utiles fixes en présence de signaux sonores constituant un bruit, provenant d'au moins un brouilleur ayant une position et/ou une nature connues.

Les termes utilisés ci-dessus doivent être pris dans un sens large. En particulier, le mot "brouilleur" désigne toute source de bruit affectant un signal sonore utile à capter, y compris éventuellement la réverbération de ce signal utile ; le terme "saisie" désigne toute prise de son aussi bien en vue de la diffusion que de l'enregistrement. Les capteurs seront généralement des microphones, mais peuvent avoir toute autre nature à condition qu'ils fournissent un signal électrique.

Le problème de l'élimination du bruit se pose fréquemment dans les dispositifs de saisie de signaux sonores. On connaît déjà des procédés permettant de le résoudre lorsque sources, brouilleurs et capteurs ont des caractéristiques et des emplacements fixes et lorsqu'il est possible de prélever sélectivement l'émission des brouilleurs à l'aide d'un capteur insensible aux signaux utiles. Bien souvent, ces conditions favorables ne sont pas remplies. On peut citer comme exemple les dispositifs de prise de son dans les salles d'audio-conférence : les sources utiles sont alors les locuteurs présents dans la pièce et les brouilleurs sont constitués par l'émission acoustique, directe et réverbérée par la salle d'écoute, d'un haut-parleur ou de haut-parleurs diffusant les signaux provenant de l'autre salle d'audio-conférence. On connaît dans ce cas le signal émis par le haut-parleur, mais, du fait des variations de la réponse acoustique de la salle, on ne peut affecter au brouilleur une position déterminée et fixe. On peut citer comme autre exemple les installations de prise de son lors du tournage d'un film : le moteur de la caméra constitue alors un brouilleur dont la position est variable et donc inconnue. On peut seulement déterminer le signal sonore du brouilleur à l'aide d'un microphone placé à proximité immédiate de la caméra et pratiquement insensible aux signaux utiles.

On connaît également (Electronics & Communication in Japon, vol. 67, n° 12, Dec. 84, pp 19-28) un dispositif de saisie de signaux sonores fournis par des sources utiles fixes en présence de bruit comprenant plusieurs capteurs fixes et au moins un capteur d'émission du brouilleur constituant chacun l'organe d'entrée d'une voie d'acquisition fournissant chacune K coefficients de la transformée de Fourier à court terme pour K bandes de fréquence particulières adjacentes, les bandes étant les mêmes pour toutes les voies d'acquisition ; et des moyens pour reconstituer les signaux sonores à partir des sorties des diverses voies qui comprennent un multiplexeur recevant les sorties des différentes voies d'acquisition et les répartissent sur K voies fréquentielles ayant chacune un bloc d'identification et un filtre. Ce bloc d'identification calcule des coefficients de corrélation.

L'invention vise à fournir un dispositif de saisie de signaux sonores répondant mieux que ceux antérieurement connus aux exigences de la pratique, notamment en ce qu'il assure une meilleure élimination de signaux sonores de brouillage provenant d'au moins un brouilleur ayant une position et/ou une nature connues,. L'invention vise plus particulièrement à éliminer, au moins en majeure partie, les brouilleurs à la seule condition qu'on connaisse leurs positions ou/et un signal fortement corrélé à ceux qu'ils émettent, a priori ou par mesure directe.

Dans ce but, l'invention propose un dispositif de saisie du type ci-dessus défini conforme à la revendication 1.

Cette disposition ne se retrouve pas dans l'article mentionné plus haut, qui décrit un dispositif ayant des voies d'acquisition principales, de capteurs utiles et des blocs de calcul de coefficients de corrélation.

L'invention sera mieux comprise à la lecture de la description qui suit de modes particuliers de réalisation de l'invention, donnés à titre d'exemples non limitatifs. La description se réfère aux dessins qui l'accompagnent, dans lesquels :
- la Figure 1 est un schéma de principe montrant la constitution d'ensemble du dispositif ;
- la Figure 2 est un synoptique montrant une constitution possible d'un des blocs d'identification du dispositif de la figure 1 ;
- la figure 3 est un schéma montrant une constitution possible d'un des estimateurs de la figure 2 ;
- les figures 4 et 5 sont des schémas montrant une constitution possible du bloc de calcul de R et d'un des blocs de calcul de S de l'estimateur de la figure 3;
- la figure 6 est un synoptique montrant une constitution possible d'un filtre utilisable dans le dispositif de la figure 1 ;
- la figure 7, similaire à la figure 6, montre une variante de réalisation.

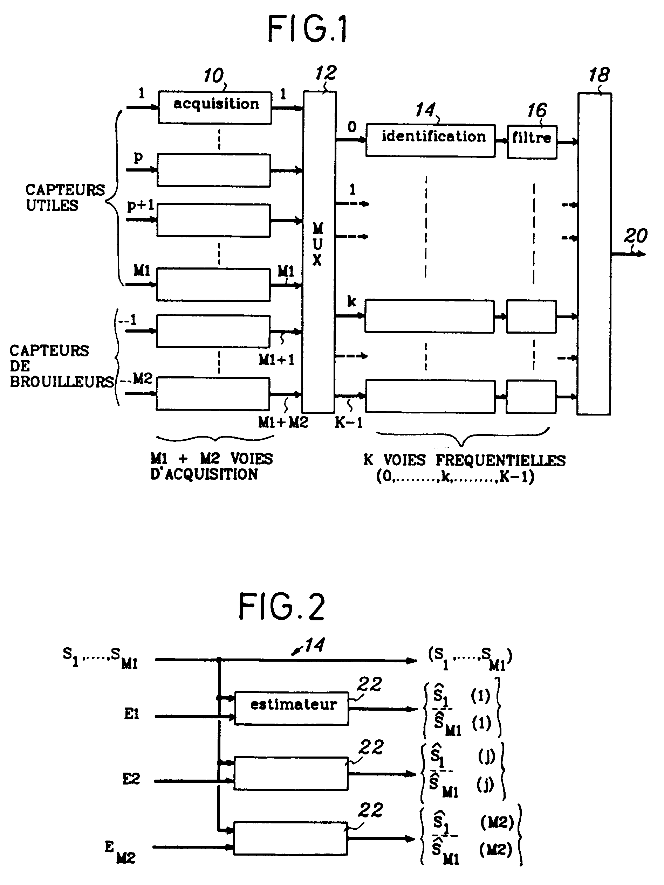

Le dispositif dont la constitution de principe est donnée en Figure 1 peut être regardé comme comprenant successivement :

- M1 + M2 voies d'acquisition ayant chacune un bloc d'acquisition 10 recevant le signal de sortie d'un capteur et fournissant la transformée de Fourier à court terme du signal reçu ;
- un multiplexeur 12 destiné à fournir les coefficients des transformées de Fourier correspondant à K fréquences ;
- K voies fréquentielles comportant chacune successivement un bloc d'identification 14 et un filtre 16, le bloc d'identification ayant pour rôle de déterminer les fonctions de transfert entre chacune des M2 brouilleurs, pris comme entrée, et chacun des signaux en provenance des capteurs utiles, d'ordre 1 à M1, pris comme sortie, et chacun des filtres ayant pour but d'éliminer l'effet des M2 brouilleurs dans une bande fréquentielle d'ordre k (avec $0 \leq k \leq K-1$) ;
- un circuit de reconstitution 18, qui peut être d'un type connu, fournissant un signal de sortie débruité à partir des contributions des K voies fréquentielles.

Ces divers composants seront décrits successivement.

Chacun des blocs d'acquisition 10 numérise les signaux fournis par un capteur correspondant, si ces signaux sont analogiques. Il a pour fonction de convertir ces signaux, par transformée de Fourier à court terme sur des tranches temporelles successives, en un flot de données temporelles et fréquentielles ; la sortie de chaque bloc d'acquisition est une mesure à K fréquences, K étant un nombre entier qui sera généralement une puissance de 2 et compris entre 128 et 1024 dans le cas où les signaux sonores sont des signaux de parole.

Sur la Figure 1 le dispositif comporte :
- M1 voies d'acquisition affectées à des capteurs de signaux utiles, d'ordre 1 ..., p, p + 1, ..., M1 ;
- M2 voies d'ordre M1 + 1, ..., M1 + M2 affectées chacune à un capteur recevant le signal d'un brouilleur.

Bloc d'acquisition

Chacun des blocs d'acquisition 10 reçoit un signal analogique ou numérique. Si le signal est analogique, il est soumis à un filtrage passe-bas puis échantillonné à une cadence Fe. Ces opérations sont inutiles en cas de signal numérique. Le bloc d'acquisition convertit ensuite le flot de données qu'il reçoit, à une cadence de un échantillon toutes les 1/Fe secondes, en un flot qui est cadencé à une fréquence Fe/N, c'est-à-dire avec une période de répétition égale à N/Fe. Au cours de chaque période de durée N/Fe, chaque bloc d'acquisition 10 fournit K coefficients complexes (c'est-à-dire 2K coefficients réels) correspondant à des fréquences successives, identiques pour tous les blocs d'acquisition 10.

Si on désigne par x les échantillons appliqués à cadence Fe à l'entrée du bloc, les données de sortie X(n,k) du bloc 10, apparaissant à des instants successifs nN/Fe (n désignant les tranches temporelles successives ayant chacune une durée N/Fe) sont de la forme :

$$X(n,k) = \sum_{i=0}^{2K-1} w_i \cdot x_{nN-2K+i} \cdot \exp\left(-j 2\pi \frac{i}{2K} k\right) \qquad (1)$$

où :
k = 0, ..., K-1
$[w_i, i = 0, ..., 2K-1]$ est une fenêtre de pondération, par exemple $w_i = 0,5(1 + \mathrm{Sin}\frac{\pi i}{2K})$.

On connaît déjà des blocs qui fournissent une transformée de Fourier à court terme du type défini par la formule (1) et en conséquence aucune description de la structure du bloc ne sera donnée.

Multiplexeur

Le multiplexeur est prévu pour fournir, dans une tranche temporelle de durée N/Fe et d'ordre n, K sorties attaquant des voies fréquentielles respectives, à partir des données $X_i(n,k)$ provenant des voies d'acquisition i = 1, ..., M1 + M2.

Chacune des sorties, par exemple la sortie d'ordre k, du multiplexeur 12 regroupe :
- M1 nombres complexes $X_i(n,k)$, pour i = 1, ..., M1, correspondant aux M1 signaux provenant des capteurs utiles;
- M2.(2L + 1) nombres complexes correspondant aux M2 brouilleurs et correspondant, pour chaque brouilleur, non pas à la seule fréquence k mais à l'ensemble des fréquences k + l avec l = L, ..., 0, ...,

+ L.

La sortie d'ordre k, c'est-à-dire pour la voie fréquentielle d'ordre k, pourra être considérée comme une réunion $S_k + E_k$ avec :

- $S_k(n,i) = X_i(n,k)$, c'est-à-dire les k-ièmes sorties, dans la tranche temporelle d'ordre n, pour le signal des capteurs de signal d'ordre i avec i = 1, ..., M1 ;
- $E_k(n,j,l) = K_{M1+j}(n,k+1)$, c'est-à-dire les k-ièmes sorties dans la tranche temporelle n, pour le signal des capteurs de brouilleurs d'ordre j, à la fréquence k et aux fréquences décalées de l, avec : j = 1, ..., M2 ; l = -L, ..., 0, ..., + L.

Dans le cas envisagé plus haut d'une saisie de parole avec K compris entre 128 et 1024, on peut adopter une valeur entière L comprise entre 5 et 10.

On peut adopter, pour k + l négatif, les valeurs :

$$E_k(n,j,l) = X_{M1+j}(n,-k-l)^*$$

où le signe $^*$ désigne le conjugué complexe et convenir que, pour $k + 1 \geq K$, $E_k$ a la valeur :

$$E_k(n,j,l) = X_{M1+j}(n,2K-k-l)^*.$$

Chaque voie fréquentielle reçoit donc, pour chaque tranche temporelle, un ensemble de signaux représentant chacun un nombre complexe X, soit en parallèle, soit successivement.

Bloc d'identification

Les blocs d'identification 14 ont la même constitution et remplissent la même fonction dans toutes les voies fréquentielles. Pour cette raison, on omettra dans ce qui suit l'indice k pour désigner les sorties $S_k$ et $E_k$ vers la voie d'ordre k.

Chaque bloc 14 reçoit ainsi :

- M1 signaux S(n,i) avec i $\in$[1,M1], c'est-à-dire les composantes de Fourier à court terme dans la tranche temporelle d'ordre n du signal reçu par les capteurs utiles ;
- M2 signaux E(n,j,l) avec j $\in$[1,M2], c'est-à-dire les composantes de Fourier à court terme dans la tranche temporelle d'ordre n du signal reçu par les capteurs de brouilleurs, à la fréquence k et à 2L fréquences autour de k.

La fonction du bloc d'identification 14 est d'identifier M1.M2 fonctions de transfert entre chacun des signaux des capteurs de brouilleurs, pris comme entrée, et chacun des signaux des capteurs utiles, pris comme sortie.

La fonction de transfert entre le capteur de brouilleur d'ordre j et le capteur utile d'ordre i peut s'écrire sous forme de l'équation récurrente :

$$\hat{S}(n,i,j) = \sum_{l=-L}^{L} \sum_{m=q_1(l)}^{q_2(l)} b_m(i,j,l)\, E(n-m,j,l) \qquad (2)$$

Les coefficients $b_m(i,j,l)$ définissent la fonction de transfert entre l'entrée d'ordre j et la sortie d'ordre i. La quantité estimée S(n,i,j) représente la part du signal brouilleur j présente dans le signal du capteur i, pendant la tranche temporelle d'ordre n. Chacun des blocs d'identification 14 peut avoir la constitution générale montrée en figure 2 qui comprend autant de voies en parallèle qu'il y a de capteurs de brouilleurs. Chaque voie reconstitue le vecteur :

$$\begin{bmatrix} \hat{S}_1(j) \\ \vdots \\ \hat{S}_{M1}(j) \end{bmatrix}$$

qui décrit la contribution du capteur de brouilleur d'ordre j (avec j $\in$[1,M2] dans le signal reçu par les capteurs d'ordre 1 à M1.

Dans la formule (2) ci-dessus les notations utilisées sont les suivantes :
- les coefficients $b_m(i,j,l)$ définissent la fonction de transfert entre l'entrée d'ordre j et la sortie d'ordre i ;
- la quantité $S(n,i,j)$ représente la fraction du signal provenant du brouilleur d'ordre j qui affecte le signal du capteur i, au cours de la tranche temporelle d'ordre n ;
- $q_1(l)$ et $q_2(l)$ sont des entiers qui caractérisent la structure de la fonction de transfert. On peut en général adopter les valeurs :

$$q_1(l) = 0 \text{ pour } l = -L, ..., L$$

$$q_2(l) = q_2(-l) \text{ pour } l = -L, ..., L$$

et l'échelonnement suivant pour les autres valeurs de l:

$$q_2(0) \geq [q_2(1) = q_2(-1)], ..., \geq [q_2(L) = q_2(-L)]$$

Les entiers $q_1$ et $q_2$ sont, dans chaque cas, particulier, évalués pour une installation déterminée et programmés une fois pour toutes.

Les coefficients $b_m$ sont calculés dans chaque bloc d'identification 14 pour chaque tranche de temps n et pour chaque sortie i par l'équation linéaire :

$$B_i(n) = R_n^{-1} \sum_{t=0}^{n} \theta_t \, S(t,i) \lambda^{n-t} \qquad (3)$$

où $R_n$ est une matrice de covariance qui sera définie plus loin ; t désigne une variable pouvant prendre toutes les valeurs entières 0 à n ; et $\lambda$ est une valeur réelle légèrement inférieure à 1, habituellement comprise entre $1-10^{-1}$ et $1-10^{-4}$, de façon à introduire un facteur d'oubli permettant de suivre les évolutions du système.

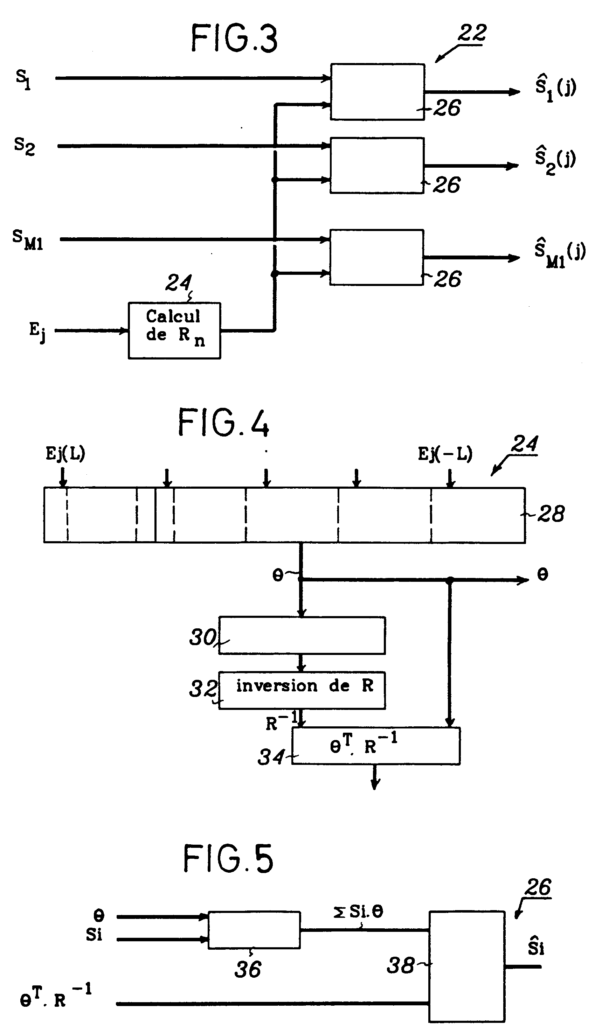

Chaque voie d'un bloc d'identification comporte un estimateur 22 qui peut avoir la constitution de principe montrée en figure 3 (où le vecteur $\theta_t$ est noté $\theta$ pour plus de simplicité) et où les indices correspondent à la voie d'ordre j de la figure 2.

L'estimateur comprend un circuit 24 effectuant, sur le signal du capteur de brouilleur $E_j$, le calcul de la covariance $R_n$ et de $\theta^T R,^{-1}$ et M1 circuits 26, tous identiques et chacun destinés à calculer l'un des termes estimés $\hat{S}_1(j), ..., \hat{S}_{M1}(j)$.

Dans la formule (3), $B_i(n)$ et $\theta_t$ représentent chacun M2 termes :

$$B_i(n) = \begin{bmatrix} \beta_i(n,1) \\ \beta_i(n,2) \\ \cdots\cdots \\ \beta_i(n,M2) \end{bmatrix} \qquad \text{et} \qquad \theta_t = \begin{bmatrix} \varepsilon(t,1) \\ \varepsilon(t,2) \\ \cdots\cdots \\ \varepsilon(t,M2) \end{bmatrix}$$

avec : (pour j = 1, ..., M2)

$$\beta_i(n,j) = \begin{Bmatrix} \beta_{q1(-L)}(i,j,-L) \\ \cdots\cdots \\ b_{q2(-L)}(i,j,-L) \\ \cdots\cdots \\ b_{q1(0)}(i,j,0) \\ \cdots\cdots \\ b_{q2(0)}(i,j,0) \\ \cdots\cdots \\ b_{q1(L)}(i,j,L) \\ \cdots\cdots \\ b_{q2(L)}(i,j,L) \end{Bmatrix} \qquad \varepsilon(t,j) = \begin{Bmatrix} E[t-q_1(-L),j,-L] \\ \cdots\cdots \\ E[t-q_2(-L),j,-L] \\ \cdots\cdots \\ E[t-q_1(0),j,0] \\ \cdots\cdots \\ E[t-q_2(0),j,0] \\ \cdots\cdots \\ E[t-q_1(L),j,L] \\ \cdots\cdots \\ E[t-q_2(L),j,L] \end{Bmatrix}$$

La matrice $R_n$, qui apparaît dans la formule (3), est la matrice de covariance :

$$R_n = \sum_{t=o}^{n} \theta_t^* \theta_t^T \lambda^{n-t} = \lambda R_{n-1} + \theta_n^* \theta_n^T \qquad (4)$$

où $\lambda$ est légèrement inférieur à 1, par exemple compris entre 0,9 et 0,9999 et qui peut être calculée par un montage du genre montré en figure 4, où l'indice n est omis pour plus de simplicité.

Le circuit 24 montré en figure 4 comprend un registre à décalage 28 muni d'une entrée d'horloge non représentée, constituant une mémoire contenant les termes Ej successifs, permettant de fournir simultanément les termes Ej(-L) à Ej(L) à un circuit 30 de calcul des poids R.

De façon plus précise, la mémoire constituée par le registre à décalage 28 contient simultanément :

$q_2(L) + 1 - q_1(L)$ termes à la fréquence k + L

$q_2(o) + 1 - q_1(o)$ termes à la fréquence k

$q_2(-L) + 1 - q_1(-L)$ termes à la fréquence k-L

L'ensemble de ces termes, c'est-à-dire le contenu du registre, constitue le vecteur $\theta$.
Le circuit 30 de calcul des poids R effectue la transformation :

$R \leftarrow \lambda R + \theta^* \theta^T$

Le résultat R est fourni, sous forme d'une matrice, au circuit de calcul 32 qui inverse la matrice et fournit sur sa sortie la valeur $R^{-1}$. Enfin, un multiplieur 34 reçoit $\theta$ et $R^{-1}$ et fournit, sur sa sortie, le produit $\theta^T.R^{-1}$.

On obtient ainsi à la sortie des différents blocs d'identification 14, pour la tranche temporelle n, les signaux S(n,i) avec $i \in [1,M1]$ qui sont les composantes de Fourier des signaux reçus par le capteur utile d'ordre i pour la tranche temporelle n.

Aux signaux S(n,i) s'ajoutent les signaux $\hat{S}(n,i,j)$ pour $i \in [1,M1]$ et pour $j \in [1,M2]$ qui sont les composantes de Fourier à court terme des signaux émis par le brouilleur j et reçus par le capteur i, toujours pour la tranche temporelle n. Chacun des circuits de calcul de $\hat{S}$ du schéma de la figure 3 peut avoir la constitution montrée en figure 5 : le circuit comporte simplement un multiplieur-accumulateur 36 recevant $\theta$ et $S_i$ et un multiplieur 38 qui reçoit le résultat du produit, c'est-à-dire $\Sigma S_i \theta$ et la sortie du circuit de calcul de $R_n$, c'est-

6

à-dire $\theta^T.R^{-1}$.

Filtres

Chacun des filtres 16 reçoit M1 signaux S(n,i) avec i∈[1,M1] et M1.M2 signaux $\hat{S}$(n,i,j) fournis par le bloc d'identification 14 correspondant. Le filtre doit fournir en sortie un signal unique y(n) constitué par la composante de Fourier à court terme, dans la tranche temporelle n, du signal reconstitué. Ce signal est élaboré suivant la relation :

$$y(n) = \sum_{i=1}^{M1} w_i(n)^* S(n,i) \qquad (5)$$

où le signe * désigne encore le conjugué complexe. Les poids $w_i$(n) sont déterminés à partir des signaux $\hat{S}$-(n,i,j) et tiennent compte de la position des sources utiles.

On affecte un gain global fixe, généralement égal à 1, à chaque fréquence et pour chaque source utile. Si on désigne par $v_r$ le gain global complexe, on en déduit les contraintes suivantes pour les poids $w_i$(n), en ce qui concerne la source utile d'ordre r :

$$\sum_{i=1}^{M1} w_i(n)^* F_{i,r} = v_r \qquad (6)$$

où $F_{i,r}$ désigne un nombre complexe constant dans le bloc, c'est-à-dire indépendant de n (mais pas de k), qui caractérise la position de la source utile d'ordre r relativement au capteur i.

On peut déduire une valeur représentative de $F_{i,r}$ de la distance $d_{i,r}$ entre le capteur d'ordre i et la source d'ordre r. Si c est la célérité moyenne du son dans l'espace entre source et capteur et Fe la fréquence d'échantillonnage du signal dans les blocs d'acquisition 10, le nombre complexe $F_{i,r}$, pour la fréquence k, est :

$$F_{i,r} = exp(-j\Pi \; Fe\frac{k}{K} \; . \; \frac{d_{i,r}}{c})$$

Le calcul des coefficients $w_i$(n) du filtre se fait par minimisation, en respectant la contrainte (6), du paramètre $\Gamma$ :

$$\Gamma = W^{*T} \varrho W \qquad\qquad (7)$$

$$\text{avec } W = \begin{bmatrix} W_1(n) \\ . \\ . \\ . \\ W_{M1}(n) \end{bmatrix}$$

et

$$Q = \sigma^2 I + \sum_{j=1}^{M2} \hat{S}_j(n).\hat{S}_j(n)^{*T} \qquad\qquad (7)$$

Dans la formule (7), le premier terme $\sigma^2 I$ permet de prendre en compte des bruits autres que ceux des brouilleurs identifiés, I étant la matrice identité et $\sigma^2$ étant un paramètre réel positif fixant la sensibilité et ajusté expérimentalement.

Le second terme de la formule (7) représente la contribution des sources de bruit, $\hat{S}_j(n)$ étant donné par :

$$\hat{S}_j(n) = \begin{bmatrix} \hat{S}(n,1,j) \\ . \\ . \\ . \\ . \\ . \\ . \\ \hat{S}(n,M1,j) \end{bmatrix}$$

Finalement, on retient pour le vecteur W la valeur donnée par :

$$w = Q^{-1}F(F^{*T}Q^{-1}F)^{-1}V$$

$$\text{avec } F = \begin{bmatrix} F_{1,1} & \cdots & F_{1,r} \\ . & . & . \\ . & \cdots & . \\ . & . & . \\ F_{M1,1} & \cdots & F_{M1,r} \end{bmatrix} \qquad V = \begin{bmatrix} V1 \\ . \\ . \\ . \\ . \\ Vr \end{bmatrix}$$

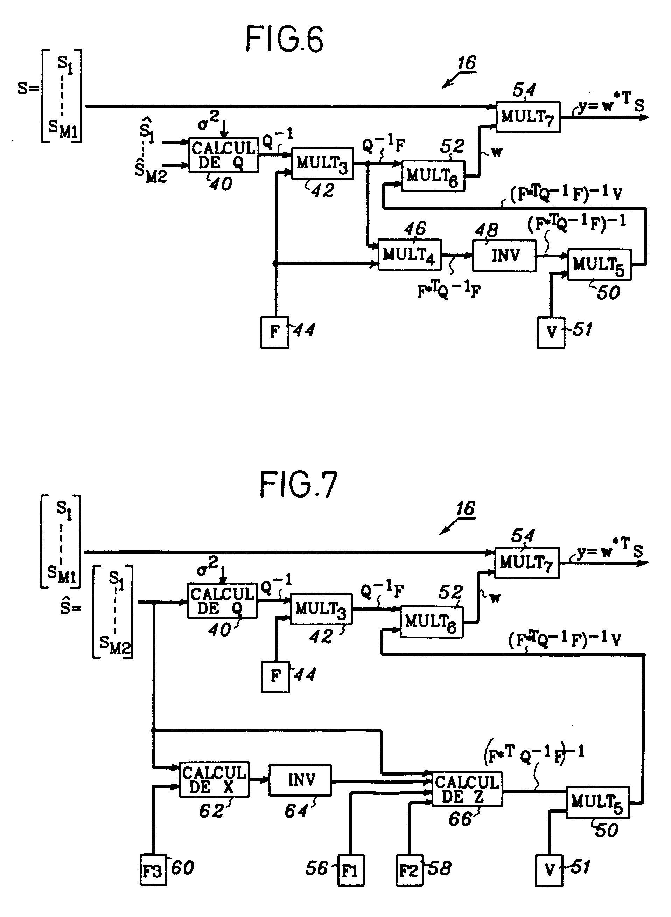

Le calcul de y(n) par la formule (5) peut être effectué à l'aide d'un filtre 16 ayant la constitution montrée en figure 6.

Ce filtre comprend un bloc 40 qui effectue le calcul de la matrice hermitienne Q par multiplications et additions :

$$Q = \sigma^2 I + \hat{S}_1 \hat{S}_1{}^{*T} + ... + \hat{S}_{M2} \hat{S}_{M2}{}^{*T}$$

puis inverse la matrice obtenue pour fournir $Q^{-1}$.

Un second montage calcule $F^{*T}Q^{-1}F$ et l'inverse. Dans le cas illustré en figure 6, ce second montage comprend un multiplieur 42 de calcul de $Q^{-1}F$, à partir de la matrice $Q^{-1}$, fournie par le bloc 40, et de la matrice F, stockée en 44. Un second multiplieur 46 fournit le produit $F^{*T}Q^{-1}F$ à partir de F et de $Q^{-1}F$. Un inverseur 48 reçoit la matrice obtenue et fournit son inverse en sortie.

La matrice inversée $(F^{*T}Q^{-1}F)^{-1}$ est appliquée à un multiplieur 50 qui reçoit également les composantes V1, ..., Vr, ... du vecteur gain V, mémorisées en 51, et fournit le résultat à un multiplieur 52. La seconde entrée du multiplieur 52 est reliée à la sortie de 42 et 50 et le multiplieur fournit le terme W de la formule (7) :

$$W = Q^{-1}F(F^{*T}Q^{-1}F)^{-1}V$$

Comme l'indique la formule (5), le signal unique y(n) constituant la transformée de Fourier à court terme pour la voie k et la tranche temporelle n est obtenu par produit de $W^{*T}$ et de $S = [S_1, ..., S_{M1}]$. Le filtre 16 comporte en conséquence un multiplieur final 54 qui détermine $W^{*T}$ à partir de W et fournit au bloc de reconstruction 18 la composante $W^{*T}S$.

Dans une variante de réalisation chaque filtre 16 met en oeuvre un algorithme différent du précédent et plus rapide pour inverser Q et $F^TQ^{-1}F$. Il utilise pour cela le lemme d'inversion :

$$(A + BCD)^{-1} = A^{-1} - A^{-1}B(C^{-1} + DA^{-1}B^{-1}DA^{-1})$$

Si on pose

$$\hat{S} = [\hat{S}_1(n), ..., \hat{S}_{M2}(n)]$$

on peut écrire la formule (7) sous la forme :

$$Q = \sigma^2 I + \hat{S}.\hat{S}^{*T}$$

et inverser Q sous la forme :

$$Q^{-1} = [I - \hat{S}(\sigma^2 I_{M2} + \hat{S}^{*T}\hat{S})^{-1}\hat{S}^{*T}]$$

où $I_{M2}$ représente la matrice identité de dimension M2 (à M2 x M2 termes),
de sorte que le terme $(F^{*T}Q^{-1}F)^{-1}$ peut s'écrire :

$$(F^{*T}Q^{-1}F)^{-1} = \sigma^2[(F^{*T}F)^{-1} + (F^{*T}F)^{-1}F^{*T}\hat{S}X^{-1}\hat{S}^{*T}F(F^{*T}F)^{-1}] \qquad (8)$$

avec

$$X = \sigma^2 I_{M2} - \hat{S}^{*T}[F(F^{*T}F)^{-1}F^{*T} - I_{M1}]\hat{S} \qquad (9)$$

où les indices de I indiquent la taille de la matrice.

Les formules (8) et (9) font intervenir des facteurs qui peuvent être calculés une fois pour toutes, pour une répartition donnée des sources et des capteurs, puis mémorisés. Il s'agit de :

$$(F^{*T}F)^{-1}$$

$$(F^{*T}F)^{-1}F^{*T}$$

9

$F(F^{*T}F^{-1})F^{*T}\text{-}I$

Cette variante est particulièrement intéressante lorsque M1 est élevé, car les matrices à inverser sont de dimension (M2,M2) au lieu de (M1,M1) dans le cas précédent. Elle peut être mise en oeuvre en utilisant des filtres ayant la constitution montrée en figure 7, où les bloc 40, 42, 50, 52 et 54 peuvent être les mêmes que sur la figure 6. L'entrée $\widehat{S}$ est constituée par une matrice dont les colonnes sont les vecteurs $\widehat{S}_1$, ..., $\widehat{S}_{M2}$. Les matrices fixes F1, F2 et F3 stockées dans des mémoires respectives 56, 58 et 60, sont :

$F1 = (F^{*T}F)^{-1}$

$F2 = (F^{*T}F)^{-1}F^{*T}$

$F3 = F(F^{*T}F^{-1})F^{*T}\text{-}I$

Le bloc 62, qui remplace le bloc 46, doit cette fois calculer, par multiplications et additions, le terme :

$X = \sigma^2 I \text{-} \widehat{S}^{*T} F_3 \widehat{S}$

qui est inversé en 64.

Le bloc suivant 66 calcule $(F^{*T}Q^{-1}F)^{-1}V$ par les produits et additions donnant :

$\sigma^2[F1 + F2\ \widehat{S}\ X^{-1}\ \widehat{S}^{*T}\ F2^{*T}]$

à partir de F1 et F2, valeurs mémorisées une fois pour toutes, $\widehat{S}$ (provenant de l'entrée) et $X^{-1}$ fourni par l'inverseur 64.

Dans le cas où il y a une seule source utile, c'est-à-dire où $\Gamma = 1$, la quantité $(F^{*T}\ Q^{-1}\ F)$ est un nombre réel : elle peut donc être inversée directement, sans qu'il soit nécessaire de recourir à la relation (8).

Circuit de reconstruction

Le circuit de reconstruction 18 comporte K entrées, constituées par les K signaux $y_k(n)$ de sortie des filtres 16 (avec $0 \leq k < K\text{-}1$). A partir de ces signaux, qui apparaissent à la cadence Fe/N, le circuit 18 doit restituer sur sa sortie 20 un signal unique $y_t$ constitué d'échantillons à cadence Fe.

Pour cela, le circuit 18 est prévu pour effectuer la transformation de Fourier inverse fournissant la valeur estimée $\widehat{y}(n,t)$ à partir des $y_k(n)$.

En posant $y_k(n) = y_{2K-k}(n)$ si $k \geq N$ ;

$$
\begin{cases}
y(n,t) = \displaystyle\sum_{k=0}^{2K-1} y_k(n)\ e^{[+j\ 2\pi \frac{k}{2K}\ (t - \frac{nN}{Fe})]} \\[2em]
\text{pour } t = \frac{nN}{0 q Fe},\ \ldots,\ t = \frac{nN}{Fe} + 2K\text{-}1\ ;
\end{cases}
$$

$$
\begin{cases}
\text{et } y(n,t) = 0 \\[2em]
\text{pour les autres valeurs de } t\ ;
\end{cases}
$$

la sortie $y_t$ s'obtient en additionnant tous les termes y(n,t) non nuls.

Il existe déjà des circuits câblés ou programmés pour fournir la transformée de Fourier inverse d'une fonction représentée par des signaux échantillonnés, de sorte qu'il n'est pas nécessaire de décrire une constitution du circuit de reconstruction 18, du fait qu'il ne comporte qu'un additionneur en plus des circuits de transformée de Fourier inverse.

La Figure 1 montre le dispositif regroupé en un seul ensemble. Mais cette constitution n'est pas indispensable. En particulier, les signaux de sortie des K voies fréquentielles peuvent être multiplexés et transmis sur un support câblé ou hertzien approprié jusqu'à un emplacement de réception. Le circuit de reconstruction 18 est alors placé à l'emplacement de réception et précédé d'un démultiplexeur lui fournissant, successivement ou en parallèle, les valeurs $y_k(n)$.

**Revendications**

1. Dispositif de saisie de signaux sonores fournis par des sources utiles fixes, en présence de signaux sonores de brouillage provenant d'au moins un brouilleur ayant une position et/ou une nature connues, comprenant plusieurs capteurs fixes de sources utiles et au moins un capteur d'émission du brouilleur, constituant chacun l'organe d'entrée d'une voie d'acquisition parmi plusieurs voies fournissant chacune les k coefficients de la transformée de Fourier à court terme pour K bandes de fréquence particulières adjacentes, les bandes étant les mêmes pour toutes les voies d'acquisition (10) ; et des moyens pour reconstituer les signaux sonores à partir des sorties des diverses voies, qui comprennent un multiplexeur (12) recevant les sorties des différentes voies d'acquisition et les répartissant sur K voies fréquentielles ayant chacune un bloc d'identification (14) et un filtre (16),
   caractérisé en ce que le bloc d'identification (14) de chaque voie fréquentielle d'ordre k (avec $0 \leq k \leq K-1$) est alimenté par les contributions de toutes les voies d'acquisition (10) à la fréquence d'ordre k et aussi par la contribution du capteur ou des capteurs de signaux de brouilleur et est constitué de façon à identifier M1.M2 fonctions de transfert entre chacun des signaux des M2 capteurs de brouilleurs, pris comme entrée, et chacun des signaux des M1 capteurs de sources utiles, pris comme sortie afin de déterminer les caractéristiques du brouilleur ou des brouilleurs pour donner au filtre (16) de la voie fréquentielle d'ordre k les caractéristiques nécessaires à l'élimination de la contribution du brouilleur ou des brouilleurs dans la voie d'ordre k.

2. Dispositif selon la revendication 1, caractérisé en ce que le multiplexeur applique à chaque bloc d'identification (14) :
   - les composantes de Fourier à court terme, dans la tranche temporelle d'ordre n, du signal reçu par tous les M1 capteurs de sources utiles ;
   - les composantes de Fourier à court terme, dans la tranche temporelle d'ordre n, du signal reçu par tous les capteurs de brouilleurs, à la fréquence k et à au moins une fréquence voisine et décalée de k.

3. Dispositif selon la revendication 1 ou 2, caractérisé en ce que le bloc d'identification pour la voie k comporte :
   - une voie directe de transmission des signaux ($S_1$,..., $S_{M1}$) fournis par les capteurs de sources utiles dans la voie k,
   - M2 estimateurs (22) en parallèle destinés à fournir chacun les valeurs estimées ($S_1$,..., $S_{M1}$) de toutes les composantes de Fourier à court terme des signaux fournis par les brouilleurs et reçus par un des capteurs de signaux utiles.

4. Dispositif selon la revendication 3, caractérisé en ce que chaque filtre (16) est prévu pour fournir un signal unique constitué par la transformée de Fourier à court terme y(n) d'un signal reconstitué dans chaque tranche temporelle :

$$y(n) = \sum_{i=1}^{M1} w_i(n)^* \, S(n,i)$$

où

$w_i$  désigne des coefficients fixes qui dépendent de la position des sources utiles et des valeurs $\hat{S}_1,...,\hat{S}_{M\,1}$ des composantes de Fourier à court terme des signaux fournis par le ou les brouilleurs et reçus par les capteurs de sources utiles.

$*$  désigne la conjuguée complexe

$S(n,i)$  désigne les signaux provenant des capteurs utiles pour la tranche temporelle d'ordre n.

**5.** Dispositif selon la revendication 4, caractérisé en ce que les moyens de reconstitution comprennent également un circuit de reconstitution (18) effectuant la transformée de Fourier inverse sur les signaux reçus des filtres et leur sommation.

**6.** Dispositif selon la revendication 4, caractérisé par des moyens pour calculer les coefficients $w_i$ par minimisation des paramètres

$$\Gamma = W^{*T}QW$$

où

$$Q = \sigma^2 I + \hat{S}_1 \hat{S}_1^{*T} + \ldots + \hat{S}_{M2} \hat{S}_{M2}^{*T}$$

I étant la matrice identité, $\sigma^2$ un paramètre expérimental, et les termes en $S.S^{*T}$ représentant la contribution des sources de bruits.

**Claims**

**1.** A device for picking up sound signals delivered by stationary useful sources in the presence of interference sound signals originating from at least one interference emitter having a known position and/or nature, comprising a plurality of stationary useful source pick-ups and at least one interference emission pick-up, each constituting the input element of an acquisition channel out of a plurality of channels each delivering the k coefficients of the short-term Fourier transform for K adjacent specific frequency bands, the bands being the same for all the acquisition channels (10); and means for restoring the sound signals from the output of the various channels, which comprise a multiplexer (12) receiving the outputs of the different acquisition channels and distributing them over K frequency channels each having an identification block (14) and a filter (16),
characterised in that the identification block (14) of each frequency channel of order k (where $0 \leq k \leq K-1$) is fed by the contributions of all the acquisition channels (10) at the frequency of order k and also by the contribution of the or each interference signal pick-up and is so devised as to identify M1.M2 transfer functions between each of the signals of the M2 interference emitter pick-ups, taken as the input, and each of the signals of the M1 useful source pick-ups, taken as the output, in order to determine the characteristics of the or each interference emitter to give the filter (16) of the frequency channel of order k the characteristics required to eliminate the contribution of the or each interference emitter in the channel of order k.

**2.** A device according to claim 1, characterised in that the multiplexer applies to each identification block (14):
- the short-term Fourier components in the time slot of order n, of the signal received by all the M1 useful source pick-ups;
- the short-term Fourier components, in the time slot of order n, of the signal received by all the interference pick-ups, at frequency k and at at least one adjacent frequency offset from k.

**3.** A device according to claim 1 or 2, characterised in that the identification block for the channel k comprises:
- a direct channel for transmission of the signals ($S_1,\ldots, S_{M1}$) delivered by the useful source pick-ups in the channel k,
- M2 estimators (22) in parallel intended each to deliver the estimated values ($S_1,\ldots, S_{M1}$) of all the short-term Fourier components of the signals delivered by the interference emitters and received by one of the useful signal pick-ups.

**4.** A device according to claim 3, characterised in that each filter (16) is adapted to deliver a single signal constituted by the short-term Fourier transform y(n) of a signal restored in each time slot:

$$y(n) = \sum_{i=1}^{M1} w_i(n)^* \, S(n,i)$$

where

   $w_i$      denotes fixed coefficients which depend on the position of the useful sources and the values $\hat{S}_1, ..., \hat{S}_{M1}$ of the short-term Fourier components of the signals delivered by the or each interference emitter and received by the useful source pick-ups,

   *        denotes the complex conjugate

   $S(n,i)$  denotes the signals originating from the useful pick-ups for the time slot of order n.

5. A device according to claim 4, characterised in that the restoration means also comprise a restoration circuit (18) effecting the inverse Fourier transformer on the signals received from the filters and their summation.

6. A device according to claim 4, characterised by means for calculating the coefficients $w_i$ by minimisation of the parameters

$$\Gamma = W^{*T}QW$$

where

$$Q = \sigma^2 I + \hat{S}_1 \, \hat{S}_1^{*T} + ... + \hat{S}_{M2} \, \hat{S}_{M2}^{*T}$$

I being the identity matrix, $\sigma^2$ an experimental parameter and the terms in $S.S^{*T}$ representing the contribution of the noise sources.

**Patentansprüche**

1. Vorrichtung zur Erfassung von Schallsignalen, welche von festen Nutzquellen kommen, in Gegenwart von Störgeräuschsignalen, welche von wenigstens einer Störgeräuschquelle bekannter Position und/oder bekannter Art kommen, umfassend mehrere feste Aufnehmer für die Nutzquellen und wenigstens einen Aufnehmer für die Störgeräuschquellenemission, von denen jeder das Eingangselement eines Erfassungskanals unter mehreren Kanälen bildet, welche jeweils die k Koeffizienten der schnellen Fourier-Transformation für K bestimmmte, benachbarte Frequenzbänder liefern, wobei die Bänder für alle Erfassungskanäle (10) die gleichen sind; und Mittel zum Rekonstituieren der Schallsignale aus Ausgangssignalen der verschiedenen Kanäle, welche Mittel einen Multiplexer (12) umfassen, der die Ausgangssignale der verschiedenen Erfassungskanäle aufnimmt und sie auf K jeweils einen Identifikationsblock (14) und ein Filter (16) aufweisende Frequenzkanäle verteilt, **dadurch gekennzeichnet**, daß dem Identifikationsblock (14) jedes Frequenzkanals der Ordnung k (mit $0 \leq k \leq K-1$) die Beiträge aller Erfassungskanäle (10) zur Frequenz der Ordnung k und auch der Beitrag des Aufnehmers oder der Aufnehmer der Störgeräuschsignale zugeführt werden und daß er derart aufgebaut ist, daß er M1.M2 Übertragungsfunktionen zwischen jedem der als Eingangssignal genommenen Signale der M2 Aufnehmer der Störgeräuschquellen und jedem der als Ausgangssignal genommenen Signale der M1 Aufnehmer der Nutzquellen zum Bestimmen der Charakteristiken der Störgeräuschquelle oder der Störgeräuschquellen identifiziert, um dem Filter (16) des Frequenzkanals der Ordnung k die zur Eliminierung des Beitrags der Störgeräuschquelle oder der Störgeräuschquellen in dem Kanal der Ordnung k notwendigen Charakteristiken zu geben.

2. Vorrichtung nach Anspruch 1, **dadurch gekennzeichnet**, daß der Multiplexer jedem Identifikationsblock (14) zuführt:
   - in dem Zeitabschnitt der Ordnung n die Komponenten der schnellen Fourier-Transformation des von allen M1 Aufnehmern der Nutzquellen empfangenen Signals;
   - in dem Zeitabschnitt der Ordnung n die Komponenten der schnellen Fourier-Transformation des von allen Aufnehmern der Störgeräuschquellen bei der Frequenz k und bei wenigstens einer benachbarten und von k verschobenen Frequenz empfangenen Signals.

3. Vorrichtung nach Anspruch 1 oder 2, **dadurch gekennzeichnet**, daß der Identifikationsblock für den Kanal k umfaßt:

   - einen Kanal zur direkten Übertragung der von den Aufnehmern der Nutzquellen in dem Kanal k gelieferten Signale ($S_1$, ..., $S_{M1}$)
   - M2 parallel angeordnete Abschätzelemente (22), von denen jedes dazu bestimmt ist, die abgeschätzten Werte ($S_1$, ..., $S_{M1}$) aller Komponenten der schnellen Fourier-Transformation der von den Störgeräuschquellen gelieferten und von einem der Nutzsignalaufnehmer empfangenen Signale zu liefern.

4. Vorrichtung nach Anspruch 3, **dadurch gekennzeichnet**, daß jedes Filter (16) dazu vorgesehen ist, ein eindeutiges Signal zu liefern, welches von der schnellen Fourier-Transformierten y(n) eines in jedem zeitlichen Abschnitt rekonstituierten Signals gebildet ist:

$$y(n) = \sum_{i=1}^{M1} w_i(n)^* \, S(n,i)$$

wobei

$w_i$      feste Koeffizienten bezeichnet, welche von der Position der Nutzquellen und den Werten $\widehat{S}_1,...,\widehat{S}_{M1}$ der Komponenten der schnellen Fourier-Transformation der von der oder den Störgeräuschquellen kommenden und von den Aufnehmern der Nutzquellen empfangenen Signale abhängen,

$*$      konjugiert komplex bezeichnet

$S(n,i)$      die Signale bezeichnet, welche von den Nutzaufnehmern für den Zeitabschnitt der Ordnung n kommen.

5. Vorrichtung nach Anspruch 4, **dadurch gekennzeichnet**, daß die Rekonstitutionsmittel auch eine Rekonstitutionsschaltung (18) umfassen, welche die inverse Fourier-Transformation der von den Filtern empfangenen Signale und deren Summierung durchführt.

6. Vorrichtung nach Anspruch 4, gekennzeichnet durch Mittel zum Berechnen der Koeffizienten $w_i$ durch Minimierung der Parameter

$$\Gamma = W^{*T}QW$$

mit

$$Q = \sigma^2 I + \widehat{S}_1 \, \widehat{S}_1{}^*T + ... + \widehat{S}_{M2} \, \widehat{S}_{M2}{}^*T$$

wobei I die Einheitsmatrix, $\sigma^2$ ein experimenteller Parameter und die $S.S^{*T}$ - Terme den Beitrag der Rauschquellen repräsentieren.

14

# FIG.1

CAPTEURS UTILES

CAPTEURS DE BROUILLEURS

M1 + M2 VOIES D'ACQUISITION

K VOIES FREQUENTIELLES
$(0,\ldots\ldots,k,\ldots\ldots,K-1)$

# FIG.2

# FIG.3

$S_1$ → [ 26 ] → $\hat{S}_1(j)$

$S_2$ → [ 26 ] → $\hat{S}_2(j)$

$S_{M1}$ → [ 26 ] → $\hat{S}_{M1}(j)$

22

$E_j$ → [ Calcul de $R_n$ ] 24

# FIG.4

Ej(L) ... Ej(−L) 24

[ 28 ]

$\Theta$ ~ → $\Theta$

30 [ ]

32 [ inversion de R ]

$R^{-1}$

34 [ $\Theta^T . R^{-1}$ ]

# FIG.5

$\Theta$ →
$S_i$ → [ 36 ] → $\Sigma S_i . \Theta$ → [ 38 ] → $\hat{S}_i$

26

$\Theta^T . R^{-1}$ →

16

# FIG.6

$$S = \begin{bmatrix} S_1 \\ \vdots \\ S_{M1} \end{bmatrix}$$

_16_

$\hat{S}_1$

$\hat{S}_{M2}$

$\sigma^2$

CALCUL DE Q
_40_

$Q^{-1}$

MULT$_3$
_42_

$Q^{-1}F$

_52_

MULT$_6$

w

_54_
MULT$_7$

$y = w^{*T}S$

MULT$_4$
_46_

$F^{*T}Q^{-1}F$

INV
_48_

$(F^{*T}Q^{-1}F)^{-1}$

$(F^{*T}Q^{-1}F)^{-1}V$

MULT$_5$
_50_

F _44_

V _51_

# FIG.7

$$\begin{bmatrix} S_1 \\ \vdots \\ S_{M1} \end{bmatrix}$$

$$\hat{S} = \begin{bmatrix} S_1 \\ \vdots \\ S_{M2} \end{bmatrix}$$

_16_

$\sigma^2$

CALCUL DE Q
_40_

$Q^{-1}$

MULT$_3$
_42_

$Q^{-1}F$

_52_

MULT$_6$

w

_54_
MULT$_7$

$y = w^{*T}S$

$(F^{*T}Q^{-1}F)^{-1}V$

F _44_

CALCUL DE X
_62_

INV
_64_

$(F^{*T}Q^{-1}F)^{-1}$

CALCUL DE Z
_66_

MULT$_5$
_50_

F3 _60_

56 F1

F2 _58_

V _51_